(19) Europäisches Patentamt
European Patent Office
Office européen des brevets

(11) **EP 1 623 240 B1**

(12) **EUROPÄISCHE PATENTSCHRIFT**

(45) Veröffentlichungstag und Bekanntmachung des Hinweises auf die Patenterteilung:
**09.04.2008 Patentblatt 2008/15**

(21) Anmeldenummer: **04728169.6**

(22) Anmeldetag: **19.04.2004**

(51) Int Cl.:
*G01R 31/06* (2006.01)     *G01R 31/34* (2006.01)
*G01R 31/12* (2006.01)     *G01R 31/08* (2006.01)

(86) Internationale Anmeldenummer:
**PCT/EP2004/004147**

(87) Internationale Veröffentlichungsnummer:
**WO 2004/099800 (18.11.2004 Gazette 2004/47)**

(54) **MESSEINRICHTUNG UND VERFAHREN ZUR ORTUNG EINER TEILENTLADUNG**

MEASURING DEVICE, AND METHOD FOR LOCATING A PARTIAL DISCHARGE

DISPOSITIF DE MESURE ET PROCEDE DE LOCALISATION D'UNE DECHARGE PARTIELLE

(84) Benannte Vertragsstaaten:
**CH DE ES GB IT LI PL**

(30) Priorität: **09.05.2003 DE 10321085**

(43) Veröffentlichungstag der Anmeldung:
**08.02.2006 Patentblatt 2006/06**

(73) Patentinhaber: **SIEMENS AKTIENGESELLSCHAFT**
**80333 München (DE)**

(72) Erfinder:
• **KOCH, Roland**
 **99096 Erfurt (DE)**
• **WEIDNER, Jürgen, R.**
 **45277 Essen (DE)**

(56) Entgegenhaltungen:
**EP-A- 0 408 813      EP-A- 0 805 355**
**WO-A-00/42444      US-A- 4 570 231**
**US-A- 5 530 364      US-A- 5 814 998**
**US-A1- 2002 014 890**

• **SEDDING H G ET AL: "A NEW SENSOR FOR DETECTING PARTIAL DISCHARGES IN OPERATING TURBINE GENERATORS" IEEE TRANSACTIONS ON ENERGY CONVERSION, IEEE INC. NEW YORK, US, Bd. 6, Nr. 4, 1. Dezember 1991 (1991-12-01), Seiten 700-706, XP000275156 ISSN: 0885-8969**
• **YONG-JOO KIM ET AL: "A partial discharge coupler for global VPI (CGVPL) rotating machines" CONFERENCE RECORD OF THE 2002 IEEE INTERNATIONAL SYMPOSIUM ON ELECTRICAL INSULATION. (ISEI 2002). BOSTON, MA, APRIL 7 - 10, 2002, INTERNATIONAL SYMPOSIUM ON ELECTRICAL INSULATION, NEW YORK, NY : IEEE, US, 7. April 2002 (2002-04-07), Seiten 19-22, XP010588786 ISBN: 0-7803-7337-5**

EP 1 623 240 B1

## Beschreibung

Die Erfindung betrifft eine Messeinrichtung und ein Verfahren zur Ortung einer Teilentladung bei einem eine elektrische Außenisolierung aufweisenden Leiterstab einer dynamoelektrischen Maschine sowie einen Sensor zum Ermitteln von Teilentladungen.

Aufgrund der einsetzenden und in naher Zukunft weiter zu erwartenden Veränderungen des Elektrizitätsmarktes ist die kostenoptimierte und unterbrechungsfreie Erzeugung und Verteilung elektrischer Energie für Energieversorgungsunternehmen wünschenswert. Von besonderer Bedeutung sind hierbei Generatoren, deren Ausfall hohe finanzielle Aufwendungen verursacht, so dass ein wachsendes Interesse daran besteht, die Betriebszuverlässigkeit zu erhöhen.

Motoren, Generatoren und dergleichen weisen typischerweise einen Rotor auf, der in einem Statorkern drehbar gelagert ist. Der Statorkern weist Statorwicklungen auf, die aus isolierten Bündeln von Leitungen bestehen, die als. Statorstäbe bekannt sind, welche in Schlitze des Statorkerns eingebettet sind.

Die Hochspannungsleiter sind in der Regel isoliert. Die. Isolation, die derartige Hochspannungsleiter umgibt, verschlechtert sich mit der Zeit. Durch eine Verschlechterung der Isolation bzw. der Eigenschaften der Isolation, kann es zu einer teilweisen Entladungsaktivität innerhalb der Isolation kommen. Diese Entladungsaktivität verschlechtert weiter die Eigenschaften der Isolation. Schädigungen können durch lokal begrenzte Durchschläge in Folge von Feldstärkeüberhöhungen im Isoliermedium entstehen. Diese Durchschläge schädigen die Isolierung langfristig. Eine zunehmende Verschlechterung der Isolation führt zu einer stärker werdenden teilweisen Entladungsaktivität, was wiederum die Verschlechterung der Isolation beschleunigt.

Eventuell muss ein isolierter Leiter, der eine teilweise Entladungsaktivität erfährt, ersetzt werden, um einen Fehler bzw. Ausfall in den Statorwicklungen zu vermeiden oder zu korrigieren. Der Motor oder Generator muss hierbei außer Betrieb gesetzt und auseinander genommen werden. Dies ist ein kosten- und zeitaufwändiger Prozess. Es ist daher vorteilhaft, wenn man in der Lage ist, den Zustand der Isolation in den Statorwicklungen schon im Voraus zu bestimmen, um vorherzusagen, ob und näherungsweise wann eine Reparatur erforderlich sein wird, so dass die Reparatur auf geordnete und wohlorganisierte Weise vorgenommen werden kann, bevor der Fehler bzw. die Fehlfunktion auftaucht, und zu einem Zeitpunkt, der bezüglich des Betriebsplanes des speziellen Motors oder Generators, der betroffen ist, am besten geeignet ist.

Teilentladungsaktivitäten können durch unterschiedliche Methoden nachgewiesen werden, insbesondere durch chemische, akustische oder elektrische Methoden. Bei räumlich ausgedehnten Leitern, wie sie in Generatoren und Motoren eingesetzt werden, werden Teilentladungs-Impulse auf ihrem Weg vom Entstehungsort zum Messpunkt stark verformt, gedämpft und mit den reflektierten Teilentladungssignalen sowie äußeren Störsignalen überlagert, so dass nur in seltenen Fällen und unter großem mess- und rechentechnischem Aufwand eine Ortung der Teilentladungsquelle oder die Trennung von Teilentladungen und Störsignalen möglich ist.

Die Erfassung und Bewertung von Teilentladungen an räumlich ausgedehnten Anordnungen wie Generatoren oder ähnlichen Hochspannungsgeräten ist aufgrund der Verformung der Teilentladungssignale durch die charakteristischen Dämpfungseigenschaften sowie durch die Überlagerung mit äußeren Störsignalen häufig mit großen Schwierigkeiten verbunden.

Ein Verfahren zur Ortung von Teilentladungen ist in dem Artikel ,,Ein neuartiges Sensorsystem zur Erfassung von Teilentladungen an gießharzisolierten Transformatoren", Peter Werle, Volker Wasserberg, Hossein Borsi, Ernst Gockenbach, Schering-Institut für Hochspannungstechnik und Hochspannungsanlagen, Universität Hannover, Deutschland beschrieben. Danach werden Sensoren die zur Erfassung von Teilentladungssignalen ausgebildet sind, in äquidistanten Abständen auf einem Leiter verteilt. Eine Teilentladung breitet sich von ihrem Entstehungsort in beide Richtungen des Leiterstabes aus. Die Sensoren, die dem Ort der Entstehung der Teilentladung am nächsten angeordnet sind, erfassen das ausgeprägteste Signal. Durch eine Auswerteeinheit, die mit allen Sensoren verbunden ist, kann hierbei der Ort einer Teilentladung ermittelt werden. Nachteilig bei diesem Verfahren ist, dass nicht der genaue Ort der Teilentladung ermittelt wird, sondern ein Bereich zwischen zwei Sensoren als möglicher Ort der Entstehung einer Teilentladung ermittelt wird.

Ein weiteres Verfahren zur Ortung von Teilentladungen an Transformatoren und ähnlichen Hochspannungsgeräten ist in der DE 100 05 540 A1 beschrieben. Hierbei wird gemäss einer Systemtheorie durch eine Faltung einer Übertragungsfunktion und an äußeren Klemmen gemessenen Teilentladungssignalen eine Ortung der Teilentladungsquelle ermöglicht. Dies erfolgt, indem die Übereinstimmung der zurückgerechneten Eingangssignale mit dem am wahren Entstehungsort erzeugten Teilentladungssignal am größten ist.

In der DE 689 22 727 T4 ist ein weiteres Verfahren und eine Vorrichtung für die Teilentladungsdetektion angegeben. Hierbei wird mittels eines Sensors ein Signal erfasst, das von einer Teilentladung herrührt. Durch Analyse des Signals wird mit einer relativ großen Fehlerwahrscheinlichkeit, der Entstehungsort einer Teilentladung lokalisiert.

Weitere Verfahren und Vorrichtungen zur Teilentladungserkennung sind in der DE 197 58 087 A1 und in der DE 199 62 834 A1 beschrieben.

Das Dokument US-5530364 A beschreibt ein Teitentladungsmesssystem basierend auf zwei beabstandet angeordneten Sensoren. Diese Sensoren sind flexibel und bilden im Wesentlichen jeweils eine Messspule die um den zu testenden Leiter liegt. Weitere Teilentladungsmesssysteme mit zwei beanstandet angeordneten Sensoren sind aus US5814998 A, US2002/014890 A, EP0805355 A und US4570231 A bekannt. Details zu Teilentladungssensoren mit einer Messelektrode und einer Schirmelektrode sind aus den Dokumenten "A New Sensor System for detecting partial discharges in operating turbine generators" von H.G. Sedding et al., IEEE Transactions on Energy Conversion, Vol. 6, No. 4, 01.12.1991, New York und EP0408813 A bekannt.

Der Erfindung liegt die Aufgabe zugrunde eine Messeinrichtung und ein Verfahren anzugeben mit denen es möglich ist, eine Teilentladung bei einem eine elektrische Außenisolierung aufweisenden Leiterstabes zu orten. Eine weitere Aufgabe der Erfindung ist es, einen Sensor anzugeben, mit dem Teilentladungen ermittelt werden können.

Die auf die Messeinrichtung hin gerichtete Aufgabe wird durch eine Messeinrichtung gemäß Anspruch 1 gelost.

Der Vorteil der Messeinrichtung besteht insbesondere darin, dass der Ort durch eine Laufzeitmessung ermittelt wird. Am Entstehungsort der Teilentladung entsteht ein Teilentladungssignal, das sich in beide Richtungen des Leiterstabs ausbreitet. Das sich ausbreitende Signal wird durch den ersten und zweiten Sensor erfasst. Über eine Laufzeitmessung wird der Entstehungsort der Teilentladung ermittelt. Diese Messeinrichtung ist weitgehend unabhängig von der Form des Teilentladungssignals. In gängigen Teilentladungsortungsverfahren werden in der Regel die Signalformen ausgewertet und daraus der Entstehungsort ermittelt. Die Ergebnisse dieser Verfahren zeigen hohe Fehlerquoten. In der erfindungsgemäßen Messeinrichtung wird nicht eine Form des von der Teilentladung herrührenden Signals, sondern der Zeitpunkt des Eintreffens des von der Teilentladung herrührenden Signals bei dem ersten oder zweiten Sensor ausgewertet.

Es können hierbei Teilentladungsquellen auf einzelnen Leiterstäben, Formspulen oder Ständerwicklungen genauer geortet werden als durch Dämpfungsvergleich ermittelte Teilentladungen.

Da keine mechanische Abtastung des Leiterstabes erfolgt, sind Messzeiten kürzer als bei Messungen mit Ultraschallsensoren.

Unter anderem können Fortschritte bei der Qualitätskontrolle ganzgetränkter Generatoren erzielt werden.

Die Leiterstäbe können auf lokale Schwachstellen untersucht werden. Die Bewertung älterer Leiterstäbe zur möglichen Wiederverwendung in neuen Generatoren ist daher möglich. Außerdem ist eine Prognose über eine Restlebensdauer von älteren Leiterstäben möglich.

Ein weiterer Vorteil ist, dass die Ortung einer Teilentladungsquelle innerhalb einer einzelnen Nut erfolgen kann.

Der erste oder zweite Sensor kann direkt an dem Leiterstab angebracht werden, dadurch wird das erste oder das zweite Teilentladungsausgangssignal nicht durch lange Ausbreitungswege (mehrere Nuten, Wickelkopf, Schaltverbinder und Durchführungen) verformt. Eine genauere Ortung ist hierdurch möglich.

Ebenso ist eine schnelle und gefahrlose Entfernung des ersten oder zweiten Sensors möglich.

In einer vorteilhaften Ausgestaltung weist die Auswerteeinheit einen Zeit-Differenz-Baustein mit einem ersten Zeit-Differenz-Signaleingang, einem zweiten Zeit-Differenz-Signaleingang und einem Zeit-Differenz-Ausgang auf. Am ersten Zeit-Differenz-Signaleingang liegt das erste Teilentladungsausgangssignal und am zweiten Zeit-Differenz-Signaleingang liegt das zweite Teilentladungsausgangssignal an. Die Auswerteeinheit ist derart ausgebildet, dass eine Zeit-Differenz zwischen einem Eintreffen des ersten Teilentladungsausgangssignals des ersten Sensors an dem Zeit-Differenz-Baustein und einem Eintreffen des Teilentladungsausgangssignals des zweiten Sensors an dem Zeit-Differenz-Baustein ermittelt wird und als Zeit-Differenz-Ausgangssignal am Zeit-Differenz-Ausgang anliegt. Die Auswerteeinheit weist hierbei einen Berechnungs-Baustein mit einem Berechnungseingang auf, an dem das Zeit-Differenz-Ausgangssignal anliegt und derart ausgebildet ist, dass ein Teilentladungsortungswert berechnet wird, der den Entstehungsort der Teilentladung auf dem Leiterstab angibt.

Vorteilhafterweise wird in der Auswerteeinheit der Teilentladungsortungswert ermittelt gemäss der Gleichung $l1 = (l + v \, \Delta t)/2$, wobei 1 der Abstand zwischen dem ersten und dem zweiten Sensor ist, 11 der Abstand des Entstehungsortes der Teilentladung zu dem zweiten Sensor ist, v die Ausbreitungsgeschwindigkeit der Teilentladung, $\Delta t$ die Zeit-Differenz ist.

Mit der Maßgabe, den Teilentladungsortungswert mit der vorgenannten Gleichung zu ermitteln, wird eine Messeinrichtung vorgestellt, die lediglich einen Parameter hat, der während eines Messverfahrens ermittelt wird.

Die Messeinrichtung kann in einem Generator oder in einem Transformator ihre Verwendung finden.

In vorteilhaften Ausbildungen der Erfindung wirkt der erste oder zweite Sensor als kapazitiver Sensor; der erste oder zweiter Sensor als induktiver Sensor; der erste oder zweite Sensor als Längsspannungssensor.

Allgemein nehmen induktive Sensoren eine magnetische Komponente von transversalen elektromagnetischen Wellen auf, die sich um den Leiterstab herum ausbreiten. Kapazitive Sensoren nehmen eine elektrische Komponente von transversalen elektromagnetischen Wellen auf. Längsspannungssensoren nehmen eine Spannung auf, die auf Grund eines Stromes in einer elektromagnetischen Welle in einer hochohmigen Leitschicht (Außenglimmschutz) abfällt.

Die auf das Verfahren hin gerichtete Aufgabe wird durch ein Verfahren zur Erfassung und Ortung einer Teilentladung bei einem eine elektrische Außenisolierung aufweisenden Leiterstab einer dynamoelektrischen Maschine, wobei ein erster Sensor und ein zweiter Sensor zur Erfassung von von der Teilentladung herrührenden, sich längs des Leiterstabs ausbreitenden Signalen in einem Abstand voneinander auf dem Leiterstab angebracht werden und der erste Sensor ein erstes Teilentladungsausgangssignal an eine Auswerteeinheit liefert und der zweite Sensor ein zweites Teilentladungsausgangssignal an die Auswerteeinheit liefert und mit der Auswerteeinheit mit dem Abstand und dem zeitlichen Eintreffen des ersten Teilentladungsausgangssignals und des zweiten Teilentladungsausgangssignals der Entstehungsort der Teilentladung ermittelt wird.

Die Vorteile hierbei ergeben sich wie bereits bei der Messeinrichtung erwähnt.

Die auf den Sensor hin gerichtete Aufgabe wird gelöst durch einen Sensor zum Ermitteln von Teilentladungen, wobei eine als Folie ausgebildete elektrisch leitende Elektrode mit einer Vorderseite und einer Rückseite ausgebildet ist, wobei auf die Vorderseite eine Außenisolation aufgebracht ist und an der Elektrode ein als Anschluss ausgebildetes Koaxialkabel angeordnet ist und ein Dielektrikum an der Rückseite der Elektrode befestigt ist und eine Schirmelektrode mit dem Dielektrikum mittels eines Transferklebers befestigt ist.

Der Vorteil des Sensors besteht insbesondere darin, dass Signale der Teilentladungen deutlich und unverfälscht aufgenommen werden können. Darüber hinaus ist der Sensor derart gestaltet, dass er an Orten angebracht werden kann, die schwer zugänglich sind.

In einer vorteilhaften Ausgestaltung wird die Elektrode aus einem elastischen Material hergestellt. Damit wird eine Bruchgefahr des Sensors vermieden.

In einer weiteren vorteilhaften Ausgestaltung wird die Elektrode aus Walzkupferklebefolie hergestellt. Durch die gezielte Wahl von Walzkupferklebefolie wird die Größe der Bauform minimiert. Darüber hinaus ist Walzkupferklebefolie elastisch und dadurch wird eine Zerstörung des Sensors durch Brechen minimiert.

In einer vorteilhaften Ausgestaltung ist die Elektrode aus einem Schicht-Verbund aus Polyimid und Walzkupfer gebildet. Durch die gezielte Wahl von Polyimid und Walzkupfer wird ebenfalls die Größe des Sensors beeinflusst. Die Größe des Sensors kann hierdurch minimiert werden. Darüber hinaus ist der Schicht-Verbund aus Polyimid und Walzkupfer ein elastisches Material, wodurch die Bruchgefahr der Elektrode minimiert wird.

In einer weiteren vorteilhaften Ausgestaltung besteht die Außenisolation aus den Materialien Niederdruck-Polyethylen oder Polypropylen. Mit Niederdruck-Polyethylen oder Polypropylen werden Materialien vorgestellt, die reißfest und äußerst dünn sind. Damit wird eine Erhöhung der Lebensdauer des Sensors erreicht.

In einer vorteilhaften Ausgestaltung ist das Dielektrikum aus einem geschlossenporigen FCKW-freien Polyethylenschaum gebildet. Mit der Wahl des geschlossenporigen FCKW-freien Polyethylenschaums wird ein Material vorgeschlagen, das im eingebauten Zustand mit äußeren Kräften beaufschlagt werden kann. Der Polyethylenschaum ist elastisch und kann in verschiedene Richtungen gedehnt oder gedrückt werden, ohne das der Polyethylenschaum seine Eigenschaften als Dielektrikum verliert.

In einer weiteren vorteilhaften Ausgestaltung weist die Schirmelektrode ein kupferbeschichtetes Glasfaser-Epoxidharz auf. Kupferbeschichtetes Glasfaser-Epoxidharz ist biegsam und besitzt gleichzeitig gute elektrische Leitfähigkeit. Der Einsatz dieses Materials als Schirmelektrode in einem Sensor, der im eingebauten Zustand äußeren Kräften ausgesetzt ist, ist geradezu ideal.

Die Schirmelektrode weist zweckmäßigerweise eine Dicke von 0,30mm bis 0,60mm, im wesentlichen 0,48 mm, auf.

Um die Messgenauigkeit zu erhöhen, wird die Elektrode zweigeteilt. Der Sensor findet Verwendung als induktiver, kapazitiver oder als Längsspannungssensor.

Anhand der Beschreibung und der Figuren werden Ausführungsbeispiele der Erfindung beschrieben. Dabei haben mit denselben Bezugszeichen versehene Komponenten diegleiche Funktionsweise.

Dabei zeigen:

Figur 1    Ein stark vereinfachter Ausschnitt eines Statorgehäuses eines Generators;
Figur 2    Eine Darstellung eines Messprinzips;
Figur 3    Darstellung eines erfassten Signals;
Figur 4    Darstellung eines ausgewerteten Signals;
Figur 5    Darstellung eines Teils eines Signals
Figur 6    Darstellung eines Teils eines zweiten Signals;
Figur 7    Draufsicht eines Sensors;
Figur 8    Schnittbild eines Sensors;
Figur 9    Schnittbild eines Sensors in eingebautem Zustand;
Figur 10   Darstellung einer Messanordnung.
Figur 11   Darstellung einer Messeinrichtung und einer Auswerteeinheit

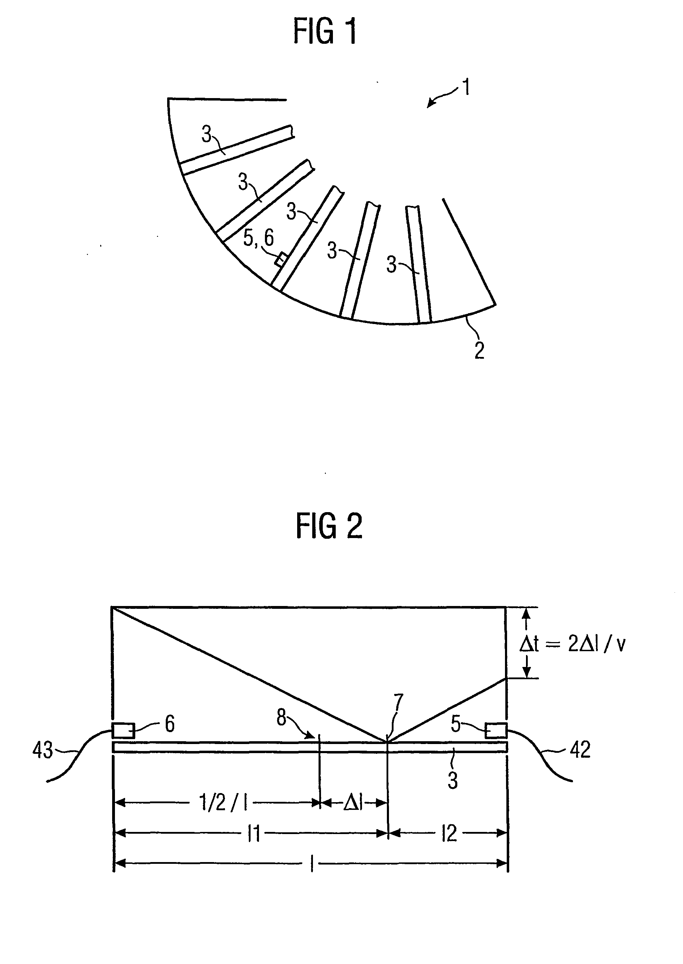

In Figur 1 ist ein stark vereinfachter Ausschnitt einer dynamoelektrischen Maschine 1 dargestellt. Unter einer dynamoelektrischen Maschine ist ein Transformator oder ein Generator zu verstehen. Ein nicht dargestellter Rotor rotiert um eine Rotationsachse in einem Statorgehäuse 2. Im Statorgehäuse 2 sind eine elektrische Außenisolierung aufweisende Leiterstäbe 3 eingebaut. Ein Sensor 5,6 ist an einem Ende des Leiterstabes 3 angebracht.

In Figur 2 ist eine stark vereinfachte Messanordnung dargestellt. Ein erster Sensor 5 und ein zweiter Sensor 6 werden auf eine Oberfläche des Leiterstabes 3 angebracht. Der erste 5 und zweite 6 Sensor sind zum Erfassen von von der Teilentladung herrührenden, sich längs des Leiterstabes 3 ausbreitenden Signalen ausgebildet. Der erste Sensor 5 ist zum Ausgeben von einem einen ersten Erfassungszeitpunkt wiedergebenden, am ersten Sensor 5 anliegenden ersten Teilentladungsausgangssignal 42 ausgebildet. Der zweite Sensor 6 ist zum Ausgeben von einem einen zweiten Erfassungszeitpunkt wiedergebenden, am zweiten Sensor 6 anliegenden Teilentladungsausgangssignal 43 ausgebildet. Am Entstehungsort 7 auf dem Leiterstab 3 entsteht eine Teilentladung in Folge einer schadhaften Isolierung. Die Teilentladung breitet sich als Signal zum einen in Richtung des ersten Sensors 5 und zum anderen in Richtung des zweiten Sensors 6 aus. Der erste Sensor 5 und der zweite Sensor 6 sind in einem Abstand 1 voneinander auf dem Leiterstab 3 angebracht.

Das erste Teilentladungsausgangssignal 42 und das zweite Teilentladungsausgangssignal 43 werden einer in Figur 2 nicht näher dargestellten Auswerteeinheit 44 zugeführt. Die Auswerteeinheit 44 ist zur Ortung der Teilentladung auf dem Leiterstab 3 ausgebildet.

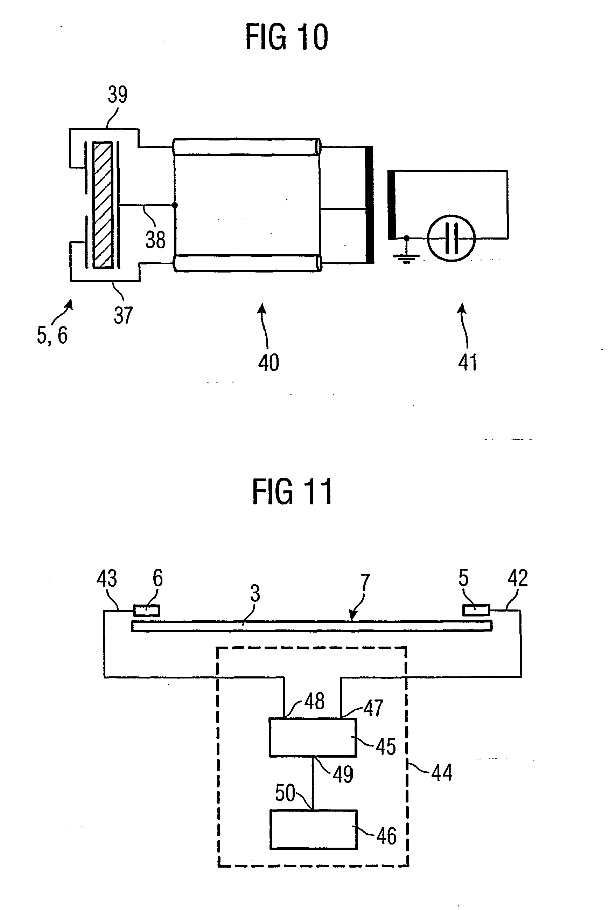

In Figur 11 ist eine Darstellung der Messeinrichtung und der Auswerteeinheit 44 zu sehen. Die Auswerteeinheit 44 weist einen Zeit-Differenz-Baustein 45 mit einem ersten Zeit-Differenz-Signaleingang 47, einem zweiten Zeit-Differenz-Signaleingang 48 und einem Zeit-Differenz-Ausgang 49 auf. Am ersten Zeit-Differenz-Signaleingang 47 liegt das erste Teilentladungssausgangssignal 42 und am zweiten Zeit-Differenz-Signaleingang 48 liegt das zweite Teilentladungssausgangssignal 43 an.

Die Auswerteeinheit 44 ermittelt eine Zeit-Differenz zwischen einem Eintreffen des ersten Teilentladungssausgangssignals 42 des ersten Sensors 5 an dem Zeit-Differenzier-Baustein 45 und einem Eintreffen des zweiten Teilentladungssausgangssignal 43 des zweiten Sensors 6 an dem Zeit-Differenzier-Baustein 45. Der Wert der Zeit-Differenz liegt als Zeit-Differenz-Ausgangssignal am Zeit-Differenz-Ausgang 49 an.

Die Auswerteeinheit 44 weist einen Berechnungs-Baustein 46 mit einem Berechnungseingang 50 auf. An dem Berechnungseingang 50 liegt das Zeit-Differenz-Ausgangssignal an. Im Berechnungs-Baustein 46 wird ein Teilentladungsortungswert berechnet, der den Entstehungsort 7 der Teilentladung auf dem Leiterstab 3 angibt.

Wie in Figur 2 dargestellt, ist die Mitte 8 des Leiterstabes 3 genau 1/2 1 vom ersten Sensor 5 und vom zweiten Sensor 6 entfernt. In dem in Figur 2 dargestellten Ausführungsbeispiel ist der Entstehungsort 7 der Teilentladung um die Länge 12 vom ersten Sensor 5 und um die Länge 11 vom zweiten Sensor 6 entfernt. Der Abstand des Entstehungsortes 7 der Teilentladung zur Mitte 8 des Leitungsstabes 3 ist Δl.

Es gilt folgende Gleichung:

$$\Delta l = l1 - l/2 = l/2 - l2.$$

Ein Teilentladungssignal, das am Entstehungsort 7 entsteht und sich in Richtung des ersten Sensors 5 und zweiten Sensors 6 ausbreitet, trifft bei einer konstanten Ausbreitungsgeschwindigkeit v am weiter entfernten zweiten Sensor 6 um die Zeitdifferenz

$$\Delta t = t1 - t2 = 2\Delta l / v$$

später ein als am ersten Sensor 5.

Der Abstand 11 des Entstehungsortes 7 vom zweiten Sensor 6 beträgt dann

$$l1 = (l + v \times (t1 - t2))/2.$$

Die am Entstehungsort 7 entstehende Teilentladung befindet sich in der Regel im Nutbereich einer Ständerwicklung.

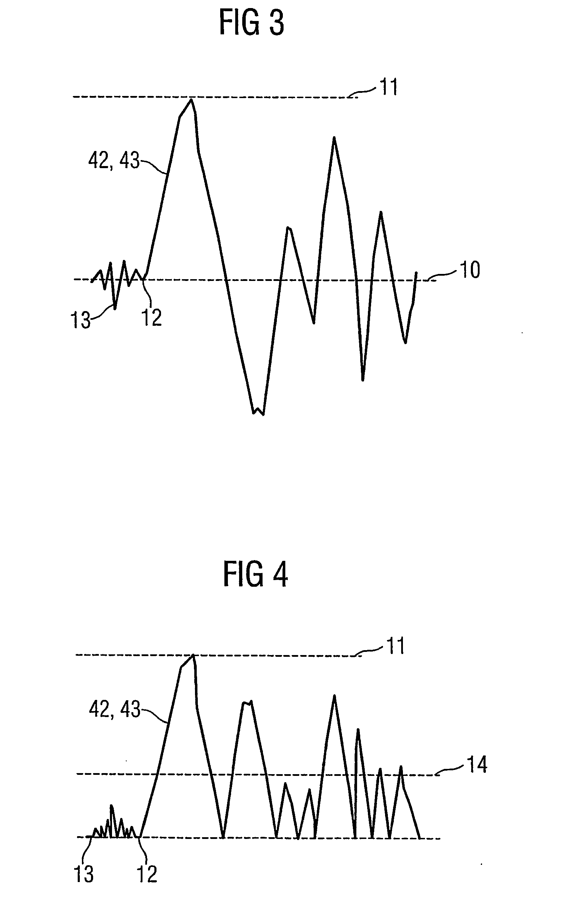

Wesentlich für das Messverfahren ist ein geeignetes Verfahren zur Zeitmessung. Es ist möglich, die Zeitmessung digital durchzuführen. In Figur 3 ist beispielhaft das durch den ersten 5 oder zweiten 6 Sensor erfasste erste 42 oder zweite 43 Teilentladungsausgangssignal dargestellt. Die mit einer gestrichelten Linie in willkürlichen Einheiten angegebene X-Koordinate 10 ist als Zeitachse zu verstehen. Auf einer nicht dargestellten Y-Achse wird eine Amplitude des ersten 42 oder zweiten 43 Teilentladungsausgangssignals dargestellt. Die Darstellung des ersten 42 oder zweiten 43 Teilentladungsausgangssignals auf der Y-Koordinate ist in willkürlichen Einheiten aufgetragen. Zusätzlich zu dem ersten 42 oder zweiten 43 Teilentladungsausgangssignal wird ein Maximalwert 11 durch eine gestrichelte Linie dargestellt.

In der Figur 4 ist der Betrag des in Figur 3 dargestellten Teilentladungsausgangssignals 42, 43 in einer X-, Y-Darstellung dargestellt.

Durch die Auswertung des Betrages des ersten 42 oder zweiten 43 Teilentladungsausgangssignals kann ein Schwingungsverhalten des ersten 42 oder zweiten 43 Teilentladungsausgangssignals berücksichtigt werden.

Mit der Eintreffzeit 12 ist der Zeitpunkt des Eintreffens des von der Teilentladung herrührenden Signals am ersten 5 oder zweiten 6 Sensor zu verstehen. Durch die Darstellung des Betrages des ersten 42 oder zweiten 43 Teilentladungsausgangssignals kann ein Signalrauschen 13 deutlich vom ersten 42 oder zweiten 43 Teilentladungsausgangssignal getrennt werden.

20% des Maximalwerts 11 wird durch eine 20%-Hilfslinie 14 dargestellt. Das erste 42 oder zweite 43 Teilentladungsausgangssignal wird erst ab einer Überschreitung der 20%-Hilfslinie als brauchbares Signal gewertet.

Durch Festlegung der 20%-Hilfslinie ist die Messeinrichtung weitgehend unabhängig von einem Grundrauschen des von der Teilentladung herrührenden Signals.

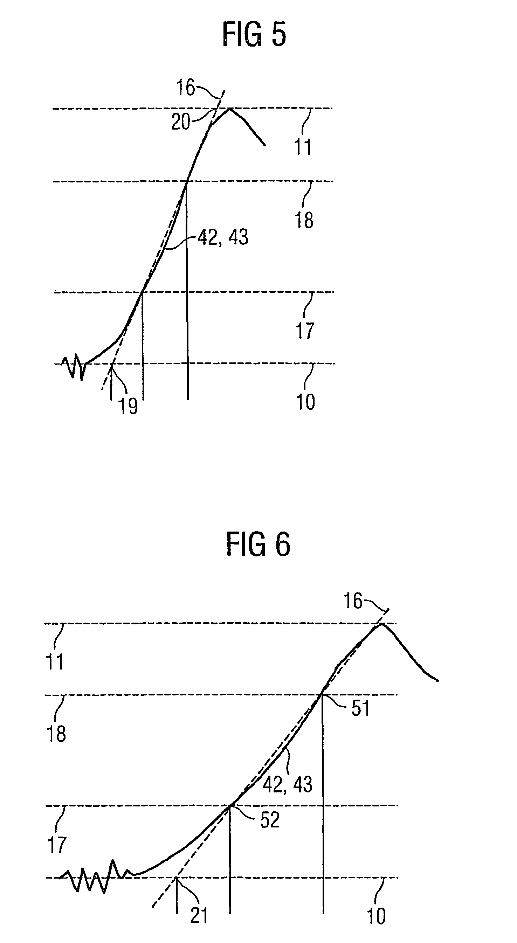

In Figur 5 ist ein Teil des ersten 42 oder zweiten 43 Teilentladungsausgangssignals dargestellt. 30% des Maximalwerts 11 werden durch eine 30%-Hilfslinie 16 dargestellt. 70% des Maximalwerts 11 werden durch eine 70%-Hilfslinie 17 dargestellt. Der Verlauf des ersten 42 oder zweiten 43 Teilentladungsausgangssignals von einem Minimalwert 19 zu einem Maximalwert 11 wird durch eine Hilfstangente 16 dargestellt. Die Hilfstangente 16 wird durch eine Gerade definiert, die durch einen ersten Schnittpunkt 51, gebildet durch einen Schnittpunkt zwischen dem ersten 42 oder zweiten 43 Teilentladungsgausgangssignal und der 70%-Hilfslinie 18 und einem zweiten Schnittpunkt 52, gebildet durch einen Schnittpunkt zwischen dem ersten 42 oder zweiten 43 Teilentladungsgausgangssignal und der 30%-Hilfslinie 17.

In Figur 6 ist ein anderes zeitliches Verhalten des ersten 42 oder zweiten 43 Teilentladungsausgangssignals dargestellt. Bei einem flacheren Anstieg des ersten 42 oder zweiten 43 Teilentladungsausgangssignals ist es unter Umständen schwierig, ein genaues Eintreffen des von der Teilentladung herrührenden Signals zu bestimmen. Man kann in diesem Fall nicht genau sagen, wann das Signal eintrifft. Die Hilfstangente 16 schneidet die X-Koordinate 10 in der Hilfs-Eintreffzeit 21. Die Hilfs-Eintreffzeit 21 kann als der Zeitpunkt des Eintreffens des von der Teilentladung herrührenden Signals definiert werden.

Durch die Einführung der 30%-Hilfslinie und der 70%-Hilfslinie und der Hilfstangente 16 wird der in Figur 6 dargestellte flache Anstieg des ersten 42 oder zweiten 43 Teilentladungsausgangssignal berücksichtigt und dadurch die Messgenauigkeit erhöht.

Dadurch ist eine Unterscheidung zwischen auffälligen Teilentladungsimpulsen und normalen alterungsbedingten Teilentladungen möglich.

Der erste 5 oder zweite 6 Sensor ist als kapazitiv wirkender oder induktiv wirkender oder als Längsspannungssensor wirkender Sensor auf dem Leiterstab 3 angebracht.

Die Messeinrichtung kann in einem Generator oder in einem Transformator verwendet werden.

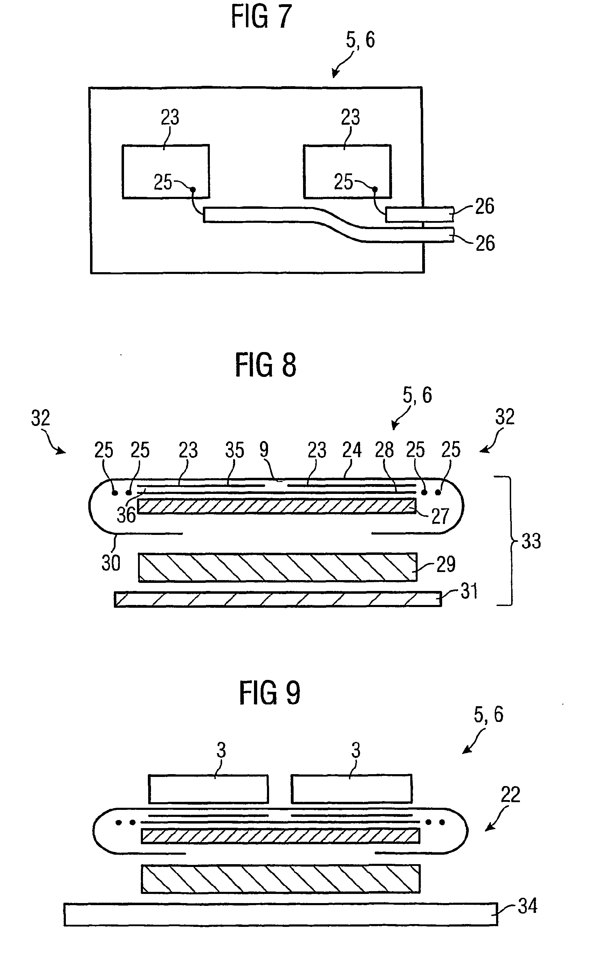

In den Figuren 7, 8 und 9 ist der Aufbau des ersten 5 oder zweiten 6 Sensors dargestellt. In Figur 7 ist eine Draufsicht auf den ersten 5 oder zweiten 6 Sensor dargestellt. Wie in Figur 8 dargestellt, ist eine als Folie ausgebildete elektrisch leitende Elektrode 23 mit einer Vorderseite 35 und einer Rückseite 36 mit einer Außenisolation 24 auf der Vorderseite 35 verbunden. Die Elektrode 23 wird über Anschlüsse 25 mit Koaxialkabeln 26 verbunden. Der in Figur 7 dargestellte erste 5 oder zweite 6 Sensor ist mit insgesamt vier Elektroden 23 ausgebildet.

In Figur 8 ist ein Schnitt durch den ersten 5 oder zweiten 6 Sensor dargestellt. Die Elektrode 23 ist mit einer Außenisolation 24 verbunden, um Erdschleifen zwischen den Sensoren 5, 6 und einer Hochspannungsanlage zu vermeiden. Ein aus nichtleitendem elastischen Material hergestelltes Dielektrikum 27 ist mittels eines Transferklebers 28 an der Rückseite 36 der Elektrode 23 verbunden. Ein weiteres Dielektrikum 29 wird an eine Unterseite 30 des ersten 5 oder zweiten 6 Sensors angebracht.

Eine Schirmelektrode 31 wird an dem weiteren Dielektrikum 29 angebracht. In einer alternativen Ausführungsform wird die Elektrode 23 aus einem elastischen Material hergestellt. In einer weiteren alternativen Ausführungsform wird die Elektrode aus Walzkupferklebefolie hergestellt.

Als Außenisolation 24 hat sich handelsüblicher Klebefilm (Handelsname z.B. TESA) bewährt. Paketklebeband ist quer zur Wickelrichtung nicht reißfest genug, PVC-Isolierband hat wegen des Weichmachergehalts eine zu raue und klebrige Oberfläche.

Statt die Elektrode 23 mit Klebefilm abzudecken, kann man Elektroden 23 aus Walzkupferklebefolie auf eine Innenseite 9 der Außenisolation 24 kleben. Als Materialien sind Niederdruck-Polyethylen (HD-PE) oder Polypropylen (PP) geeignet. Aufgrund der Verformbarkeit der glatten Oberfläche und der Haftung der Walzkupferklebefolie ist eine PET-Folie (Normbezeichnung: F1515, Handelsname: Hostapan) geeignet. Die Anschlüsse 25 werden an die Elektrode 23 angelötet.

Als Dielektrikum 27 wird ein geschlossenporiger FCKW-freier PE-Schaum, der als Polstermaterial für Verpakkungen und Trittschalldämmung im Handel ist, verwendet. Die Koaxialkabel 26 sind an einem Rand 32 des Dielektrikums 27 unter der umgefalteten Außenisolation 24 mittels Transferkleber 28 festgeklebt. Die Schirmelektrode 31 ist aus kupferbeschichtetem Glasfaser-Epoxidharz mit einer Stärke von 0,40mm bis 0,60mm, vorzugsweise 0,48 mm, hergestellt. Eine Gesamtdicke 33 des ersten 5 oder zweiten 6 Sensors ist durch eine weitere Zwischenlage aus einem nicht näher dargestelltem zusätzlichen Dielektrikum an den Abstand zwischen dem Leiterstab 3 und einem Druckfinger 34 anpassbar.

In einer alternativen Ausführungsform wird die Elektrode 23 aus Polyimid und Walzkupfer hergestellt.

Die in Figur 8 und Figur 9 dargestellte Elektrode 23 ist zweigeteilt.

In Figur 10 ist ein Messprinzip dargestellt. Der erste 5 oder zweite 6 Sensor wird über drei Leitungen 37, 38, 39 an einen Symmetrieübertrager 11 angekoppelt. Der Symmetrieübertrager 11 ist auch unter der Bezeichnung "balanced unbalanced transformator", kurz "balun" bekannt. An den Symmetrieübertrager 11 ist eine Erfassungseinheit 41 zur Darstellung und Auskopplung des ersten 42 oder zweiten 43 Teilentladungsausgangssignals angekoppelt.

Bei kapazitiven und Längsspannungssensoren ist auf eine niedrige Dielektrizitätszahl zu achten. Zur Anpassung der Gesamtdicke 33 des ersten 5 oder zweiten 6 Sensors an eine Spaltbreite werden entweder das Dielektrikum 27 der entsprechenden Stärke verwendet oder das weitere Dielektrikum 29 eingesetzt.

Der erste 5 oder zweite 6 Sensor ist auch als Mehrfachsensor einsetzbar. Entsprechend der Zahl der Leiterstäbe 3 in einer Nut können mehrere Sensoren auf einem Leiterstab 3 angeordnet werden.

**Patentansprüche**

1. Messeinrichtung zur Ortung einer Teilentladung bei einem eine elektrische Außenisolierung aufweisenden Leiterstab (3) einer dynamoelektrischen Maschine (1), wobei ein erster (5) und ein zweiter (6) Sensor, die zum Erfassen von von der Teilentladung herrührenden, sich längs des Leiterstabs (3) ausbreitenden Signalen ausgebildet sind, wobei der erste Sensor (5) zum Ausgeben von einem einen ersten Erfassungszeitpunkt wiedergebenden, am ersten Sensor (5) anliegenden ersten Teilentladungsausgangssignal (42) und der zweite Sensor (6) zum Ausgeben von einem einen zweiten Erfassungszeitpunkt wiedergebenden, am zweiten Sensor (6) anliegenden zweiten Teilentladungsausgangssignals (43) ausgebildet sind, in einem Abstand (1) voneinander auf dem Leiterstab (3) angeordnet sind und das erste Teilentladungsausgangssignal (42) und das zweite Teilentladungsausgangssignal (43) einer Auswerteeinheit (44) zugeführt sind, die zur Ortung der Teilentladung auf dem Leiterstab (3) ausgebildet ist, wobei der Sensor (5, 6) zum Ermitteln von Teilentladungen ausgebildet ist, wobei eine als Folie ausgebildete elektrisch leitende Elektrode (23) mit einer Vorderseite (35) und einer Rückseite (36), wobei auf die Vorderseite (35) eine Außenisolation (24) aufgebracht ist und an der Elektrode (23) zwei als Anschlüsse (25) ausgebildete Koaxialkabel (26) angeordnet sind und ein Dielektrikum (27) an der Rückseite (36) der Elektrode (23) befestigt ist und eine Schirmelektrode (31) mit dem Dielektrikum (27) mittels eines Transferklebers (28) befestigt ist,

   **dadurch gekennzeichnet, dass**

   das Dielektrikum (27) aus einem geschlossenporigen FCKW-freien Polyethylenschaum gebildet ist.

2. Messeinrichtung nach Anspruch 1,

   **dadurch gekennzeichnet, dass** die Auswerteeinheit (44) einen Zeit-Differenz-Baustein (45) mit einem ersten Zeit-Differenz-Signaleingang (47), einem zweiten Zeit-Differenz-Signaleingang (48) und einem Zeit-Differenz-Ausgang (49) aufweist,

   wobei am ersten Zeit-Differenz-Signaleingang (47) das erste Teilentladungsausgangssignal (42) und am zweiten Zeit-Differenz-Signaleingang (48) das zweite Teilentladungsausgangssignal (43) anliegt, wobei die Auswerteinheit (44) derart ausgebildet ist, dass eine Zeit-Differenz zwischen einem Eintreffen des ersten Teilentladungsausgangssignals (42) des ersten Sensors (5) an dem Zeit-Differenz-Baustein (45) und einem Eintreffen des zweiten Teilentladungsausgangssignals (43) des zweiten Sensors (6) an dem Zeit-Differenz-Baustein (45) ermittelt wird und als Zeit-Differenz-Ausgangssignal am Zeit-Differenz-Ausgang (49) anliegt,

   wobei die Auswerteeinheit (44) einen Berechnungs-Baustein (46) mit einem Berechnungseingang (50) aufweist, an dem das Zeit-Differenz-Ausgangssignal anliegt und derart ausgebildet ist, dass ein Teilentladungsortungswert berechnet wird, der den Entstehungsort (7) der Teilentladung auf dem Leitungsstab (3) angibt.

3. Messeinrichtung nach Anspruch 2,

   **dadurch gekennzeichnet, dass** die Auswerteeinheit (44) zur Ermittlung des Teilentladungsortungswertes gemäss der Gleichung 11 = (1 + v Δt)/2 ausgebildet ist, wobei 1 der Abstand zwischen dem ersten (5) und dem zweiten (6) Sensor ist,

   11 der Abstand des Entstehungsortes (7) der Teilentladung zur Mitte zwischen dem ersten (5) und zweiten (6) Sensor ist,

v die Ausbreitungsgeschwindigkeit der Teilentladung, Δt die Zeit-Differenz ist.

4. Messeinrichtung nach einem der Ansprüche 1 bis 3,
**dadurch gekennzeichnet, dass** der erste (5) oder zweite (6) Sensor ein kapazitiv wirkender Sensor ist.

5. Messeinrichtung nach einem der Ansprüche 1 bis 3,
**dadurch gekennzeichnet, dass** der erste (5) oder zweite (6) Sensor ein induktiv wirkender Sensor ist.

6. Messeinrichtung nach einem der Ansprüche 1 bis 3,
**dadurch gekennzeichnet, dass** der erste (5) oder zweite (6) Sensor ein Längsspannungssensor ist.

7. Verwendung der Messeinrichtung nach einem der Ansprüche 1 bis 6 in einem Generator .

8. Verwendung der Messeinrichtung nach einem der Ansprüche 1 bis 6 in einem Transformator.

9. Messeinrichtung nach einem der Ansprüche 1 bis 6,
**dadurch gekennzeichnet, dass** die Elektrode (23) aus einem elastischen Material hergestellt ist.

10. Messeinrichtung nach einem der Ansprüche 1 bis 6,
**dadurch gekennzeichnet, dass** die Elektrode (23) aus Walzkupferklebefolie hergestellt ist.

11. Messeinrichtung nach einem der Ansprüche 1 bis 6,
**dadurch gekennzeichnet, dass** die Elektrode (23) aus einem Schicht-Verbund aus Polyimid und Walzkupfer gebildet ist.

12. Messeinrichtung nach einem der Ansprüche 1 bis 6,
**dadurch gekennzeichnet, dass** die Außenisolation (24) aus dem Material Niederdruckpolyethylen oder Polypropylen hergestellt ist.

13. Messeinrichtung nach einem der Ansprüche 1 bis 6,
**dadurch gekennzeichnet, dass** die Schirmelektrode (31) kupferbeschichtetes Glasfaser-Epoxidharz aufweist.

14. Messeinrichtung nach einem der Ansprüche 1 bis 6,
**dadurch gekennzeichnet, dass** die Schirmelektrode (31) eine Dicke zwischen 0,30mm und 0,60mm aufweist.

15. Messeinrichtung nach einem der vorhergehenden Ansprüche,
**dadurch gekennzeichnet, dass** die Elektrode (23) zweigeteilt ist.

**Claims**

1. Measuring device for locating a partial discharge on a conductor bar (3), which has electrical external insulation, in a dynamoelectrical machine (1),
in which
a first sensor (5) and a second sensor (6), which are designed to detect signals which are caused by the partial discharge and propagate along the conductor bar (3), with the first sensor (5) being designed to emit a first partial discharge output signal (42), which reflects a first detection time and is applied to the first sensor (5) and with the second sensor (6) being designed to emit a second partial discharge output signal (43), which reflects a second detection time and is applied to the second sensor (6) are arranged at a distance (1) from one another on the conductor bar (3), and the first partial discharge output signal (42) and the second partial discharge output signal (43) are supplied to an evaluation unit (44) which is designed to locate the partial discharge on the conductor bar (3), in which the sensor (5, 6) for determination of partial discharges is provided, in which an electrically conductive electrode (23) which is in the form of a sheet and has a front face (35) and a rear face (36), with external insulation (24) being applied to the front face (35) and with two coaxial cables (26), which are in the form of connections (25), being arranged on the electrode (23), with a dielectric (27) being attached to the rear face (36) of the electrode (23), and with a screening electrode (31) being attached to the dielectric (27) by means of a transfer adhesive (28),
**characterized in that**
the dielectric (27) is formed from a closed-pore polyethylene foam which is free of fluoro-chlorohydrocarbons.

**2.** Measuring device according to claim 1,
**characterized in that**
the evaluation unit (44) has a time difference module (45) with a first time difference signal input (47), a second time difference signal input (48) and a time difference output (49), with the first partial discharge output signal (42) being applied to the first time difference signal input (47), and the second partial discharge output signal (43) being applied to the second time difference signal input (48), with the evaluation unit (44) being designed such that a time difference between the arrival of the first partial discharge output signal (42) from the first sensor (5) at the time difference module (45) and the arrival of the second partial discharge output signal (43) from the second sensor (6) at the time difference module (45) is determined, and is produced as the time difference output signal at the time difference output (49), with the evaluation unit (44) having a calculation module (46) with a calculation input (50) to which the time difference output signal is applied, and which is designed such that a partial discharge location value is calculated, which indicates the point of origin (7) of the partial discharge on the conductor bar (3).

**3.** Measuring device according to claim 2,
**characterized in that**
the evaluation unit (44) is designed to determine the partial discharge location value using the equation 11 = (1 + v Δt)/2 where 1 is the distance between the first sensor (5) and the second sensor (6), 11 is the distance between the point of origin (7) of the partial discharge and the centre between the first sensor (5) and the second sensor (6), v is the propagation speed of the partial discharge, and Δt is the time difference.

**4.** Measuring device according to one of claims 1 to 3,
**characterized in that**
the first sensor (5) or the second sensor (6) is a capacitively acting sensor.

**5.** Measuring device according to one of claims 1 to 3,
**characterized in that**
the first sensor (5) or the second sensor (6) is an inductively acting sensor.

**6.** Measuring device according to one of claims 1 to 3,
**characterized in that**
the first sensor (5) or the second sensor (6) is a direct-axis voltage sensor.

**7.** Use of the measuring device according to one of claims 1 to 6 in a generator.

**8.** Use of the measuring device according to one of claims 1 to 6 in a transformer.

**9.** Measuring device according to one of claims 1 to 6,
**characterized in that**
the electrode (23) is produced from an elastic material.

**10.** Measuring device according to one of claims 1 to 6,
**characterized in that**
the electrode (23) is produced from rolled copper adhesive film.

**11.** Measuring device according to one of claims 1 to 6,
**characterized in that**
the electrode (23) is formed from a layer assembly composed of polyimide and rolled copper.

**12.** Measuring device according to one of claims 1 to 6,
**characterized in that**
the external insulation (24) is produced from the material high-density polyethylene or polypropylene.

**13.** Measuring device according to one of claims 1 to 6,
**characterized in that**
the screening electrode (31) has copper-coated glass-fiber epoxy resin.

**14.** Measuring device according to one of claims 1 to 6,
**characterized in that**

the screening electrode (31) has a thickness between 0.30 mm and 0.60 mm.

**15.** Measuring device according to one of the preceding claims,
   **characterized in that**
   the electrode (23) is in two parts.


**Revendications**

**1.** Dispositif de mesure pour localiser une décharge partielle dans une barre conductrice (3) qui comporte une isolation électrique extérieure et qui fait partie d'une machine dynamoélectrique , dans lequel un premier (5) capteur et un deuxième (6) sont conçus pour détecter des signaux qui proviennent de la décharge partielle et qui se propagent le long de la barre conductrice (3), le premier capteur (5) est conçu pour émettre un premier signal de sortie de décharge partielle (42) qui indique un premier instant de détection et qui parvient au premier capteur (5) et le deuxième capteur (6) est conçu pour émettre un deuxième signal de sortie de décharge partielle (43) qui indique un deuxième instant de détection et qui parvient au deuxième capteur (6), les deux capteurs étant à distance (1) l'un de l'autre sur la barre conductrice (3) et le premier signal de sortie de décharge partielle (42) ainsi que le deuxième signal de sortie de décharge partielle (43) sont acheminés à une unité d'exploitation (44) conçue pour localiser la décharge partielle sur la barre conductrice (3), le capteur (5 , 6) est conçu pour déterminer des décharges électriques partielles et comporte une électrode (23) électro-conductrice , sous forme de feuille , munie d'un côté avant (35) et d'un côté arrière (36), une isolation extérieure (24) étant appliquée sur le côté avant (35) et deux câbles coaxiaux (26) sous forme de raccords (25) sont appliqués à 1'électrode (23), un diélectrique (27) est fixé au côté arrière (36) de 1'électrode (23) et une électrode de protection (31) est fixée au diélectrique (27) à l'aide d'un adhésif de transfert (28),
   **caractérisé en ce que** le diélectrique (27) est en mousse de polyéthylène à pores fermées et sans hydrocarbure chlorofluoré

**2.** Dispositif de mesure selon la revendication 1, **caractérisé en ce que** l'unité d'exploitation (44) comporte un module de différence de temps (45) équipé d'un première entrée de signal de différence de temps (47), d'une deuxième entrée de signal de différence de temps (48) et d'une sortie de différence de temps (49), le premier signal de sortie de décharge partielle (42) parvenant à la première entrée de signal de différence de temps (47) et le deuxième signal de sortie de décharge partielle (43) parvenant à la deuxième entrée de signal de différence de temps (48), l'unité d'exploitation (44) y est conçue de manière à déterminer une différence de temps entre le moment où le premier signal de sortie de décharge partielle (42) du premier capteur (5) arrive au module de différence de temps (45) et le moment où le deuxième signal de sortie de décharge partielle (43) du deuxième capteur (6) arrive au module de différence de temps (45) et qu'elle parvient à la sortie de différence de temps (49) sous forme de signal de sortie de différence de temps , l'unité d'exploitation (44) comporte un module de calcul (46) équipé d'une entrée de calcul (50) auquel parvient le signal de sortie de différence de temps et est conçue de manière à calculer une valeur de localisation de décharge partielle qui donne le point d'origine (7) de la décharge partielle sur la barre conductrice (3) .

**3.** Dispositif de mesure selon la revendication 2, **caractérisé en ce que** l'unité d'exploitation (44) est conçue pour déterminer la valeur de localisation de décharge partielle d'après l'équation 1 1 = (1 + v $\Delta$t) / 2 , où 1 est la distance entre le premier (5) capteur et le deuxième (6), 1 1 la distance du point d'origine (7) de la décharge partielle par rapport au centre entre le premier (5) capteur et le deuxième (6), v est la vitesse à laquelle la décharge partielle se propage et $\Delta$t la différence de temps.

**4.** Dispositif de mesure selon l'une des revendications 1 à 3 **caractérisé en ce que** le premier (5) ou le deuxième (6) capteur est un capteur à effet capacitif .

**5.** Dispositif de mesure selon l'une des revendications 1 à 3 , **caractérisé en ce que** le premier (5) ou le deuxième (6) capteur est un capteur à effet inductif.

**6.** Dispositif de mesure selon l'une des revendications 1 à 3 , **caractérisé en ce que** le premier (5) ou le deuxième (6) capteur est un capteur à composante longitudinale de tension.

**7.** Utilisation du dispositif de mesure selon l'une des revendications 1 à 6 dans un générateur .

8. Utilisation du dispositif de mesure selon l'une des revendications 1 à 6 dans un transformateur .

9. Dispositif de mesure selon l'une des revendications 1 à 6 **caractérisé en ce que** l'électrode (23) est fabriquée en un matériau élastique.

10. Dispositif de mesure selon l'une des revendications 1 à 6 , **caractérisé en ce que** 1 'électrode (23) est fabriquée en une feuille adhésive en cuivre laminé .

11. Dispositif de mesure selon l'une des revendications 1 à 6 **caractérisé en ce que** 1 'électrode (23) est formée d'une couche composite en polyamide et en cuivre laminé.

12. Dispositif de mesure selon l'une des revendications 1 à 6 , **caractérisé en ce que** l'isolation extérieure (24) est en polyéthylène basse pression ou en polypropylène.

13. Dispositif de mesure selon l'une des revendications 1 à 6 **caractérisé en ce que** l'électrode de protection (31) comporte une résine époxy à fibres de verre et à revêtement de cuivre.

14. Dispositif de mesure selon l'une des revendications 1 à 6 , **caractérisé en ce que** 1 'électrode de protection (31) a une épaisseur comprise entre 0 ,30 mm et 0 ,60 mm.

15. Dispositif de mesure selon l'une des revendications précédentes , **caractérisé en ce que** l'électrode (23) est divisée en deux parties.

# FIG 1

# FIG 2

$$\Delta t = 2\Delta l \,/\, v$$

# FIG 3

# FIG 4

# FIG 5

# FIG 6

# FIG 7

# FIG 8

# FIG 9

## FIG 10

## FIG 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10005540 A1
- DE 68922727 T4
- DE 19758087 A1
- DE 19962834 A1
- US 5530364 A
- US 5814998 A
- US 2002014890 A
- EP 0805355 A
- US 4570231 A
- EP 0408813 A

**In der Beschreibung aufgeführte Nicht-Patentliteratur**

- **H.G. SEDDING et al.** A New Sensor System for detecting partial discharges in operating turbine generators. *IEEE Transactions on Energy Conversion,* 01. Dezember 1991, vol. 6 (4